# EUROPEAN PATENT SPECIFICATION

(11) **EP 2 766 938 B1**
(45) Date of publication and mention of the grant of the patent: **30.12.2015**
(21) Application number: 12791224.4
(22) Date of filing: 12.10.2012
(51) Int. Cl.: H01L 35/30, E04C 2/292, F24J 2/04, E04C 1/39, H02S 10/10, E04C 2/52

(54) **A WALL STRUCTURE**
WANDSTRUKTUR
STRUCTURE DE MUR

(30) Priority: 12.10.2011 GB 201117626
(43) Date of publication of application: 20.08.2014
(73) Proprietor: Elsarrag, Esam, Doha (QA); Al-Horr, Yousef, Doha (QA)
(72) Inventor: Elsarrag, Esam, Doha (QA); Al-Horr, Yousef, Doha (QA)
(74) Representative: Ablett, Graham Keith
(86) International application number: PCT/GB2012/052543
(87) International publication number: WO 2013/054136

(56) References cited:
- EP-A1- 2 239 787
- DE-A1- 19 946 806
- DE-A1-102009 022 745
- DE-U1-202009 015 903
- JP-A- 07 142 750
- JP-A- 2003 021 424
- JP-A- 2004 204 546
- KHIRE R A ET AL: "Design of thermoelectric heat pump unit for active building envelope systems", INTERNATIONAL JOURNAL OF HEAT AND MASS TRANSFER, PERGAMON PRESS, GB, vol. 48, no. 19-20, 1 September 2005 (2005-09-01), pages 4028-4040, XP027601995, ISSN: 0017-9310 [retrieved on 2005-09-01]
- MANEEWAN S ET AL: "Heat gain reduction by means of thermoelectric roof solar collector", SOLAR ENERGY, PERGAMON PRESS. OXFORD, GB, vol. 78, no. 4, 1 April 2005 (2005-04-01), pages 495-503, XP027840601, ISSN: 0038-092X [retrieved on 2005-04-01]

## Description

The present invention relates to a wall structure, and more particularly to such a structure for a building.

As the general standard of living improves, there is increasing demand for industrial and residential buildings which can provide a more comfortable environment as well as being environmentally sustainable. One way to create such an environment is to have an effective heating, ventilation and air-conditioning (HVAC) system. Such a system forms an important part of the building by providing sustainable Indoor Air Quality (IAQ) and a comfortable environment for the occupants. Over the years, there have been many studies relating to HVAC systems. For example, an insulation model for a conventional HVAC system comprising two glass skins which form a cavity within which tempered fresh air can flow, is designed to create a comfortable and habitable environment by accommodating heat and mass transfer within the system. However, this kind of design may offer very small or ineffective energy savings, unless one or both IAQ or comfort of the building are compromised.

JP 2004 204546 discloses a building structure in which a vent passage is provided for supplying an airflow to cool one side of a thermal power generating element. The air flow flows from a fresh air inlet provided at the base of the building's wall, to a fresh air outlet provided at the top of its roof.

Khire et al, 2005; Design of Thermoelectric Heat Pump Unit for Active Building Envelope Systems; International Journal of Heat and Mass Transfer; Vol. 48, no. 19-20, pages 4028-4040 discloses a building having an active building envelope.

Photovoltaic and thermoelectric units are integrated within the overall active building envelope enclosure. The photovoltaic unit forms an envelope surrounding the external wall such that a gap is maintained between the wall and the photovoltaic unit. This gap acts as an external heat dissipation zone for the thermoelectric unit.

Maneewan et al, 2005; Heat Gain Reduction by Means of Thermoelectric Roof Solar Collector; Solar Energy; Vol. 78, no. 4, pages 495-503 discloses a thermoelectric solar collector system in which ventilation fans force air to flow through an air gap provided in the roof of a building for cooling a thermoelectric module embedded therein.

Accordingly, it is an object of the present invention to seek to overcome the above problems associated with the prior art.

According to an aspect of the present invention, there is provided a wall structure for a building, comprising: a cavity for allowing air to flow through the wall structure between the building's interior and exterior, between the wall structure's inner and outer layers; and an electricity generating member for generating electricity using heat transfer and being located for transferring heat from the building's exterior to interior when exposed to relatively warm external conditions and from the building's interior to exterior when exposed to relatively cooler external conditions, and wherein the electricity generating member is located for promoting an energy transfer with air within the cavity.

In this way, the electricity generating member can generate electricity from an external heat source, such as the sun, when exposed to relatively warm external conditions (as compared to the interior of the building) and any energy which conducts through the layer can be used to warm the air within the cavity. As the air flows through the cavity, this in turn will help maintain a desired thermal level of, for example, a building to a level for the occupants. At least a portion of the energy will be converted to generate electricity by the electricity generating member. Further, in this way by controlling the air flow within the cavity the temperature of the electricity generating member can be regulated, which can be highly advantageous where such elements are highly temperature sensitive.

Conversely, when exposed to relatively cool external conditions (e.g. nighttime) where the interior of the building is warmer than the exterior, the electricity generating member can generate electricity using heat from the interior of the building. This thereby utilises a portion of the heat loss from the building (T_{HOT}, in - T_{COLD}, out) to generate electricity. At the same time, another portion of the heat loss may also used to heat ventilation air coming into the building via the cavity, thereby reducing the U value of the wall. In such a case, the wall construction works as a combined heat and power (CHP) source.

In this way, in hot climates, the electricity generating member can generate electricity from either external heat source such as the sun or heat absorbed via thermal mass thermal mass or Phase Change Material (PCM), and any energy which conducts through the layer can be used to warm the air within the cavity. Air extracted from the building will be allowed to flow through the cavity, this in turn will help to reject a high level of solar gains which severely influence the air conditioning, and a portion of the energy will be converted to generate electricity by the electricity generating member. Further, in this way, by controlling the air flow within the cavity the temperature of the electricity generating member can be regulated, which can be highly advantageous where such elements are highly temperature sensitive and reduce dramatically the need of air conditioning. The electricity generated could be used, for example, to power a local ventilating fan, data loggers, controls, sensors, LED lights, or stored for later use.

As will therefore be appreciated, the present invention therefore has dual/reversible operating modes as it can generate electricity in both hot and cold conditions, whilst using heat to warm the ventilation air in cold climates or, in warm climates, use air extracted from the building and flushed through the wall structure to reject the solar gains and the heat absorbed by external layers. In both cases, the delta T is used to generate electricity.

Conveniently, the electricity generating member is located such that energy conducted by the electricity generating member is transferable to the cavity and/or such that energy carried by the cavity is conductable to the electricity generating member.

Preferably, the electricity generating member has first and second surfaces, the electricity generating member being positioned within the structure such that the first surface is located for absorbing energy from the building's exterior and the second surface is located at or adjacent the cavity, so that when exposed to relatively warm external conditions the electricity generating member is located for generating electricity and conducting energy from its first to second surfaces for transference to air in the cavity.

Preferably, the electricity generating member comprises a thermoelectric layer and/or a photovoltaic layer. Thermoelectric materials can convert thermal energy directly into electricity, therefore the thermoelectric layer provides a simple method of heat conversion and reduces the extent to which heat energy is wasted during conversion. Further, the electricity generating member may be an organic thermoelectric material on the exterior surface.

Preferably, the wall structure further comprises an energy absorbing layer, wherein the energy absorbing layer is located at or adjacent the electricity generating member. The energy absorbing layer may function as a storage for the absorbed heat so that there will be a consistent supply of the heat energy to the electricity generating member, whether there is a surplus or shortfall of heat radiating from the heat source.

Preferably, the energy absorbing layer comprises an insuating material and/or a photovoltaic layer. The insulating material can be a thermal mass material or PCM which can store thermal energy for extended periods of time. Conventionally, such materials have been used to insulate buildings. Therefore it is preferable to use such a material with the electricity generating member, for example with the thermoelectric layer. The photovoltaic layer can absorb solar energy and convert it to electricity. This can assist to generate electricity more effectively. The excess energy which the photovoltaic layer is not able to convert can then be transferred to the thermoelectric layer and converted into electricity further. The excess energy can further be conducted to warm the air in the cavity for ventilation use in cold climates, or internal extracted air is used to cool down the photovoltaic or the photovoltaic and thermoelectric assembly in hot climates which thereby reduces solar gain, and hence heat conduction gain, as well as enhancing power generation.

Preferably, the first surface of the thermoelectric layer is provided at or adjacent the photovoltaic layer and the second surface of the thermoelectric layer is provided at or adjacent the cavity so that after a first energy conversion has occurred in the photovoltaic layer a second energy conversion can occur in the thermoelectric layer without minimising the loss of heat energy during the transfer. The thermoelectric layer uses the differential temperature between the photovoltaic layer and the cavity to generate the electricity. This ensures no or little energy is lost during the conversion/heating period in cold climates, whilst maximising heat rejection to the ambient in hot climates.

Preferably, the electricity generating member is organic thermoelectric material so that it is exposed to the exterior of the structure for absorbing solar energy.

Preferably, the electricity generating member comprises an organic thermoelectric material and/or a combination of an organic thermoelectric material as an external layer and a thick or thin film thermoelectric material.

Preferably, the wall structure further comprises an insulating layer for location at or adjacent the cavity on the opposite side of the cavity from which the electricity generating member is located, the insulating layer comprising an insulating material. This insulating layer helps the unnecessary loss of the heat energy.

Preferably, the electricity generating member is provided in a form of a planar element. In this way, the surface area for absorbing energy and transferring heat to warm the air in the cavity is maximised.

Preferably, the wall structure is provided as a panel. In this way the structure may be provided in modular form.

According to further embodiments of the present invention there may be provided a wall structure for overcoming thermal bridge issues with a non insulated wall structure comprising thermal bridges or a solid wall. In this way, the electricity generating member is positioned for generating electricity from heat conduction or loss from the wall structure and hence converts a portion of the heat loss or gain to electricity. Examples of thermal bridges, but not limited in construction, may be a Timber Frame, a precast concrete Panel, a concrete block, etc.

Illustrative embodiments of the present invention will now be described with reference to the accompanying drawings, in which:
Figure 1 shows a first embodiment of the present invention in a heating cycle;
Figure 2 shows a second embodiment of the present invention in a cooling cycle;
Figure 3 shows a third embodiment of the present invention;
Figure 4 shows a fourth embodiment of the present invention; and
Figure 5 shows a fifth embodiment of the present invention, with (a) showing the embodiment under a first, warmer, ambient condition and (b) showing the embodiment under a second, colder, ambient condition.

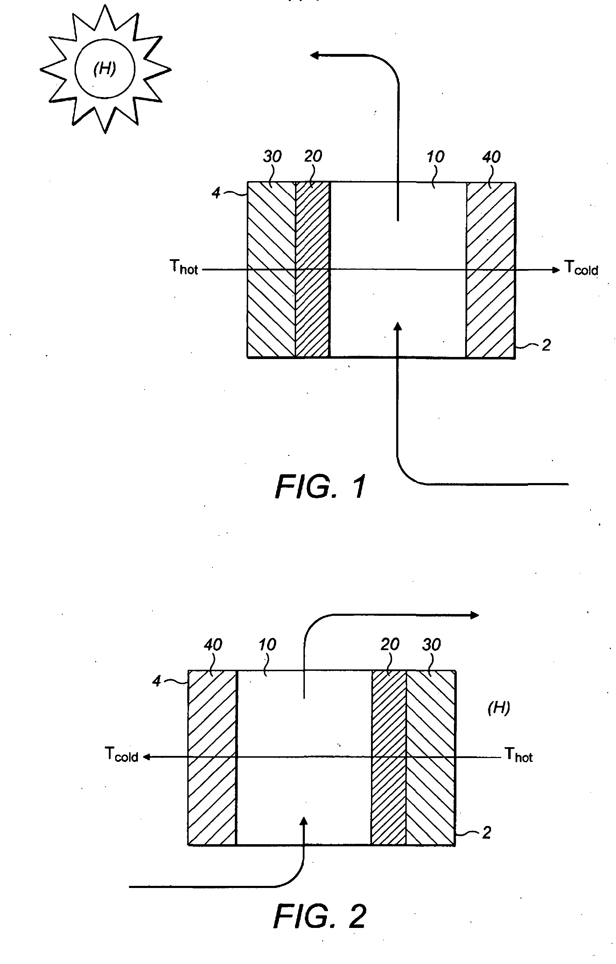

Figure 1 shows a wall structure according to a first embodiment of the present invention. As shown, the wall structure has external 4 and internal 2 layers. Between these is a cavity 10 through which air can flow from inside the structure to outside the structure, namely from inside to outside a building having the structure. An electricity generating member which comprises a thermoelectric layer 20 is located adjacent the outer layer towards a heat source (H) which in this case is the sun. Next to and outwardly of the thermoelectric layer 20 is an energy absorbing layer 30 which is located further towards the external layer 4 of the structure. An insulating layer 40 is located next to the cavity 10 towards the internal layer 2 of the structure.

Operation of the first embodiment of the present invention will now be described. Figure 1 illustrates a heating cycle, where the ambient air temperature is relatively high. This may correspond to an elevated daytime temperature or to generally high temperatures in a hot climate. In such case, air extracted from the building will be colder than the outside temperature and will flow through the cavity from inside the building to outside. In hot and humid climates, buildings are designed for positive pressure to eliminate humidity (exfiltration). In such case the air flows naturally from the interior to the exterior. The internal opening should be lower than the external opening to allow air to flow naturally, although mechanical means could also be provided to promote this airflow. In case of sand climates, such as the Gulf Region, a sand trap louver and air filters should preferably also be provided for the external layers.

Heat from the sun radiates the exposed surface of the external layer 4 and the heat is absorbed into the energy absorbing layer 30 adjacent to the external layer 4. In some embodiments, layer 4 could be provided as an organic thermoelectric layer which itself could be used to generate electricity, thereby enhancing the power generation at a first stage. The energy absorbing layer 30 conducts at least some of the heat energy to the thermoelectric layer 20 whilst additionally storing at least some of the remainder of the heat energy. Once the heat energy is conducted, the first surface of the thermoelectric layer 20 adjacent to the energy absorbing layer 40 is hotter than the second surface of the thermoelectric layer adjacent to the cavity 10. As a result of this temperature differential, the thermoelectric layer 20 generates electricity which is supplied to an electrical circuit (not shown). The electrical circuit may, for example, then be used to directly power a fan, electrical devices, feed power into the grid, or supply power to a battery storage for later use.

At the same time, the heat energy received on the first surface of the thermoelectric layer 20 is also conducted through the structure to warm the air in the cavity 10. The air flows into the cavity 10 from the interior is then warmed up and released to the exterior of the building to maintain a desired thermal level within the building.

Figure 2 shows a second embodiment of the present invention in a cooling cycle, where the ambient outdoor air temperature is relatively low and it is warmer inside the building. This may correspond to a temperature drop during night, or in a generally cold climate.

In Figure 2, an electricity generating member which comprises a thermoelectric layer 20 is located towards the interior of the building, which in this case provides a heat source (H). Adjacent to the thermoelectric layer 20 is an energy absorbing layer 30 which is located towards the internal layer 2 of the structure. On the other side of the thermoelectric layer 20 is a cavity 10 in which the fresh air flows through from the exterior to the interior of the building. An insulating layer 40 is located next to the cavity 10 towards the external layer 4 of the structure. In some embodiments, layer 4 could be provided as an organic thermoelectric layer which itself could be used to generate electricity due to the temperature difference between the cavity 10 and the exterior, thereby enhancing the overall power generation.

In this embodiment, the thermoelectric layer 20 utilises macroscopic film technology to provide a plurality of micro generators operating across the layer. Relatively small differences in temperature between an exposed first surface and a second surface adjacent to the cavity can be used to convert thermal energy directly into electricity, which is output to the electrical circuit.

In this connection, such a thin or thick film thermoelectric layer 20 can deliver power generation densities in excess of those achieved from conventional thick film devices, and are therefore preferred. For example, output power levels of >100 mW at ΔT=70K and >300 mW at ΔT=120K were achieved with modules that measured 3.5 mm x 3.5mm in size, corresponding to output power densities of ~ 1-3 W/cm².

Furthermore, the insulating layer 40 utilises a thermal mass material or PCM which is capable of storing thermal energy for extended period of time. This type of material is capable of absorbing heat energy, for example, during the daytime, to thereby reduce the cooling load on the structure and then release the heat during the night thereby reducing the heat load. Examples of such materials may include water, rock, earth, brick, concrete, fibrous cement, caliche and ceramic tile.

As mentioned above, Figure 2 illustrates a cooling cycle, for use in situations where the ambient outdoor air temperature is relatively low and it is warmer inside the building. In such conditions, the external layer 4 is exposed to the cool ambient air. The insulating layer 40 adjacent to the external layer 4 aids to minimise unnecessary loss of heat energy from the building. The energy absorbing layer 30 is located towards internal layer 2 of the structure towards the heat source. In this arrangement, the thermoelectric layer 20 functions and operates in the same way as described above in the first embodiment. The only difference is that the fresh air outside to the building enters the cavity 10 is warmed to be circulated. This will again result in the generation of electricity and maintenance of a desired thermal level within the building.

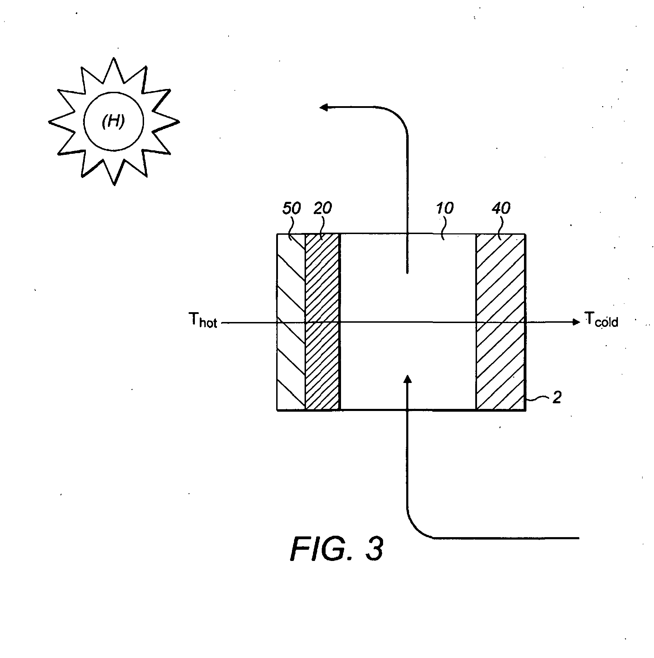

Figure 3 shows a third embodiment of the present invention. This embodiment is similar to the embodiment shown in Figure 1, except the energy absorbing layer 30 and the external layer 4 are replaced by a photovoltaic layer or organic thermoelectric layer 50. In this embodiment the photovoltaic layer 50 serves several functions including that of the energy absorbing layer 30.

During the heating cycle, the heat from the sun (H) radiates the exposed surface of photovoltaic layer or organic thermoelectric layer 50. The photovoltaic layer or organic thermoelectric layer 50 absorbs the radiation and converts the thermal energy into electricity. During absorption, the temperature of the photovoltaic layer or organic thermoelectric layer 50 will rise. Therefore, this heat energy is conducted to the first surface of thermoelectric layer 20 located adjacent to the photovoltaic layer or organic thermoelectric layer 50, causing a temperature differential between its first and second surfaces, resulting in electricity generation. By having two layers which are capable of generating electricity, the structure seeks to take optimal advantage of the available energy and minimise any waste of energy. The thermoelectric layer 20 further conducts the heat to thereby warm the air in the cavity 10, the cavity 10 being located adjacent the second surface of the thermoelectric layer 20. This air will be circulated or released to maintain a desired constant thermal level and thus high standard of IAQ in the building.

During the cooling cycle, internal air is extracted through the structure to reject the heat absorbed by the layers and, during this, the air is cooled down the photovoltaic and/or thermoelectric assembly, which accordingly enhances the electricity generating performance of the photovoltaic and/or thermoelectric assembly.

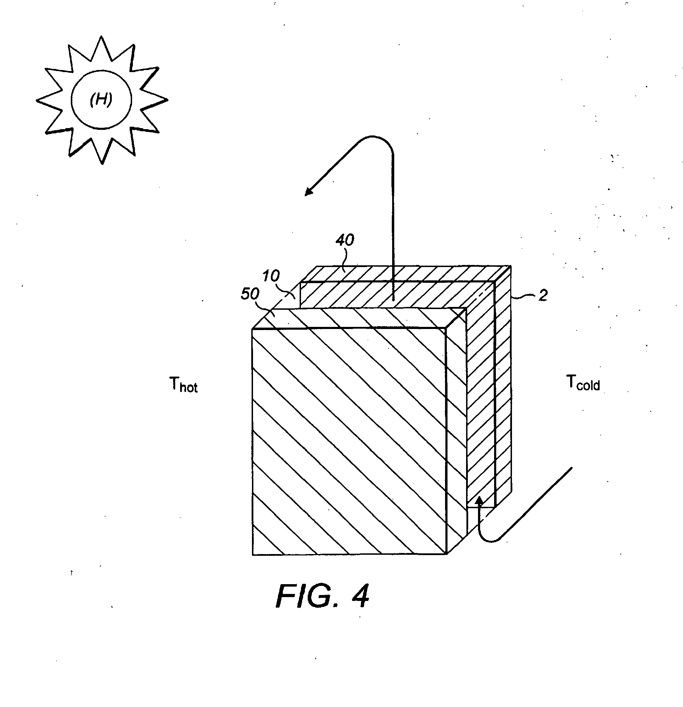

Figure 4 shows a fourth embodiment of the present invention. This embodiment is similar to the embodiment shown in Figure 1, except that a photovoltaic layer or organic thermoelectric layer 50 replaces the thermoelectric layer 20, the energy absorbing layer 30 and the external layer 4, thereby simplifying the configuration of the structure.

The photovoltaic layer or organic thermoelectric layer 50 operates in the same way as described above. However, in this embodiment, the photovoltaic layer 50 acts as both an energy absorbing layer and an electricity generating member thereby taking full advantage of the photovoltaic material's properties. Therefore, the photovoltaic layer or organic thermoelectric layer 50 absorbs the energy radiated from the sun (H), generates electricity and warms the air in the cavity 10. This results in an environmentally sustainable system, without compromising the IAQ and thermal level by utilising available energy to obtain an optimum result.

In this connection, the efficiency of photovoltaic modules is very sensitive to temperature. For example a temperature rise of 10K leads to a loss of 5% in conversion efficiency. As such, by controlling the air flow within the air cavity, the temperature of the photovoltaic module can be controlled, i.e. relatively cool air in the cavity provided from the outside, or from within a building (in hot climates) can be used to reduce the temperature of the photovoltaic modules and therefore maintain and stabilise its efficiency. In the case of the organic thermoelectric layer, the building will benefit from the heat absorbed as an electrical source.

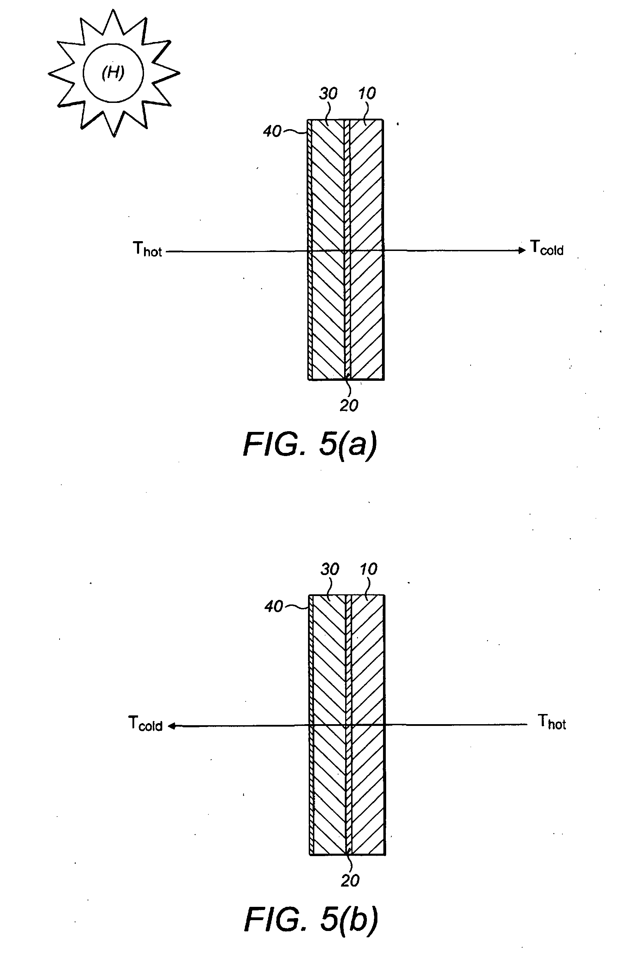

Figure 5 shows a fifth embodiment of the present invention, with (a) showing the embodiment under a first, warmer, ambient condition (e.g. daytime) and (b) showing the embodiment under a second, colder, ambient condition (e.g. nighttime). In this embodiment, there is provided an internal layer 10, a thick or thin film thermoelectric energy conversion layer 20 adjacent to the internal layer 10, a construction layer 30 adjacent to the thermoelectric energy conversion layer 20, and an outer organic thermoelectric layer 40.

The internal layer 10 is for direction towards the interior of a building and may be formed of plaster board, plaster, block, or any other suitable construction material. The construction layer 30 may be formed of concrete block or timber frame or any other suitable construction material 30.

In this embodiment the thermoelectric layer 20 converts both heat escaping from the fabric (thermal bridge) into electricity and heat gained by the fabric (thermal bridge) into electricity.

As shown in Figure 5(a), during first, warmer, ambient condition, such as daytime or in hot seasonal weather, the heat from the sun radiates the exposed surface of the organic thermoelectric layer 40. This organic thermoelectric layer 40 absorbs radiation and a portion of this energy is converted to electricity. During absorption, the temperature of the external layer 40 will rise and heat energy is conducted through the construction layer 30 to the first surface of the thermoelectric layer 20. This then causes a temperature differential between the thermoelectric layer's 20 first surface adjacent to the construction layer 30 and the thermoelectric layer's 20 second surface adjacent to internal layer 10. This thereby results in electricity generation by the thermoelectric layer 20. As such, by haying both the organic thermoelectric layer 40 and the thermoelectric layer 20 capable of generating electricity, the structure seeks to take optimal advantage of the available energy and minimise any waste of energy.

As shown in Figure 5(b), during second, cooler, ambient condition, such as nigh time or cold seasonal weather, the heat from the building's interior transfers from the internal wall layer 10. During absorption, the temperature of the internal layer 10 will rise and heat energy is conducted to the thermoelectric layer 20 causing a temperature differential between the thermoelectric layer's 20 second surface adjacent to internal layer 10 and the thermoelectric layer's 20 first surface adjacent to the construction layer 30. This thereby results in electricity generation by the thermoelectric layer 20. Again, by having two layers which are capable of generating electricity, the structure seeks to take optimal advantage of the available energy and minimise any waste of energy.

In this embodiment, the external layer 40 is an organic thermoelectric layer which absorbs the radiation and coverts a portion of this energy into electricity. However, in other embodiments, the outer organic thermoelectric layer 40 may be replaced by an external construction/cladding layer 40, which would absorb radiation but not generate electricity itself. Such an embodiment would therefore not be as effective at optimising energy recovery.

As will be appreciated from the above examples, the present invention allows surplus energy to be stored during warm conditions for certain period of time and then utilised later to generate electricity during cooler conditions. This allows for electricity to be generated over much longer periods of time, improving the overall efficiency of the energy generating apparatus.

It will be understood that the embodiments illustrated above shows applications of the invention only for the purposes of illustration and not drawn to scale. In practice the invention may be applied to many different configurations, within the scope of the claims, detailed embodiments being straightforward for those skilled in the art to implement.

For example, although in the embodiments illustrates a structure as part of a building's wall, it could be incorporated into other structures such as a building's roof or as part of the flooring. In such cases, the apparatus may be provided in the form of a panel and/or be used in a modular construction.

## Claims

1. A wall structure for a building, comprising:
a cavity (10) for allowing air to flow through the wall structure between the building's interior and exterior, between the wall structure's inner (2) and outer (4) layers; and
an electricity generating member (20) for generating electricity using heat transfer and being located for transferring heat from the building's exterior to interior when exposed to relatively warm external conditions (T_{HOT}) and from the building's interior to exterior when exposed to relatively cooler external conditions (T_{COLD}), and
wherein the electricity generating member (20) is located for promoting an energy transfer with air within the cavity (10).

2. A wall structure according to claim 1, wherein the air temperature differential between the building's interior and exterior causes air within the cavity (10) to flow from the interior to the exterior when exposed to relatively warm external conditions (T_{HOT}) and from the building's exterior to interior when exposed to relatively cooler external conditions (T_{COLD}).

3. A wall structure according to claim 1, wherein the electricity generating member (20) is located such that energy conducted by the electricity generating member (20) is transferable to the cavity (10) and/or such that energy carried by the cavity (10) is conductable to the electricity generating member (20).

4. A wall structure according to any preceding claim, wherein the electricity generating member (20) has first and second surfaces, the electricity generating member (20) being positioned within the structure such that the first surface is located for absorbing energy from the building's exterior and the second surface is located at or adjacent the cavity (10), so that when exposed to relatively warm external conditions the electricity generating member (20) is located for generating electricity and conducting energy from its first to second surfaces for transference to air in the cavity (10).

5. A wall structure according to any preceding claim, wherein the electricity generating member (20) comprises a thermoelectric layer and/or a photovoltaic layer.

6. A wall structure according to any preceding claim, further comprising an energy absorbing layer (30) or a thermal mass or PCM, wherein the energy absorbing layer (30) or thermal mass or PCM is located at or adjacent the electricity generating member (20).

7. A wall structure according to claim 6, wherein the energy absorbing layer (30) comprises an insulating material and/or a photovoltaic layer (50).

8. A wall structure according to claim 7, wherein the first surface of the thermoelectric layer is at or adjacent the photovoltaic layer (50) and the second surface of the thermoelectric layer is at or adjacent the cavity (10).

9. A wall structure according to claim 5, wherein the photovoltaic layer (50) is provided in the structure so that it is exposed to the exterior of the structure for absorbing solar energy.

10. A wall structure according to any preceding claim, wherein the electricity generating member (20) comprises an organic thermoelectric material and/or a combination of an organic thermoelectric material as an external layer and a thick or thin film thermoelectric material.

11. A wall structure according to claim 10, wherein the organic thermoelectric material is provided in the structure so that it is exposed to the exterior of the structure for absorbing solar energy.

12. A wall structure according to any preceding claim, further comprising an insulating layer for location at or adjacent the cavity (10) on the opposite side of the cavity (10 from which the electricity generating member (20) is located.

13. A wall structure according to any preceding claim, wherein the electricity generating member (20) is provided in a form of a planar element.

14. A wall structure according to any preceding claim, wherein the wall structure is provided as a panel.

15. A wall structure according to any preceding claim, wherein the wall structure functions as dynamic insulation or as a thermal bridge.

## Patentansprüche

1. Wandstruktur für ein Gebäude, umfassend:
einen Hohlraum (10) zwischen den inneren (2) und äußeren Schichten (4) der Wandstruktur, der Luft zwischen dem Gebäudeinneren und der Außenumgebung durch die Wandstruktur strömen lässt; und
ein Elektrizität erzeugendes Element (20) zur Erzeugung von Elektrizität mittels Wärmeübertragung, das so angeordnet ist, dass es Wärme aus der Außenumgebung des Gebäudes in das Gebäudeinnere überträgt, wenn es relativ warmen externen Bedingungen (T_{HOT}) ausgesetzt wird, und aus dem Gebäudeinneren an die Außenumgebung überträgt, wenn es relativ kühleren externen Bedingungen (T_{COLD}) ausgesetzt wird, und
wobei das Elektrizität erzeugende Element (20) so angeordnet ist, dass es eine Übertragung von Energie mit Luft innerhalb des Hohlraums (10) begünstigt.

2. Wandstruktur nach Anspruch 1, wobei der Lufttemperaturunterschied zwischen dem Gebäudeinneren und der Außenumgebung bewirkt, dass Luft im Hohlraum (10) aus dem Inneren zur Außenumgebung strömt, wenn sie relativ warmen externen Bedingungen (T_{HOT}) ausgesetzt wird, und von der Außenumgebung des Gebäudes zum Gebäudeinneren strömt, wenn sie relativ kühleren externen Bedingungen (T_{COLD}) ausgesetzt wird.

3. Wandstruktur nach Anspruch 1, wobei das Elektrizität erzeugende Element (20) so angeordnet ist, dass Energie, die vom Elektrizität erzeugenden Element (20) geleitet wird, auf den Hohlraum (10) übertragbar ist, und/oder so, dass Energie, die vom Hohlraum (10) getragen wird, auf das Elektrizität erzeugende Element (20) übertragbar ist.

4. Wandstruktur nach einem der vorangehenden Ansprüche, wobei das Elektrizität erzeugende Element (20) erste und zweite Oberflächen aufweist, wobei das Elektrizität erzeugende Element (20) innerhalb der Struktur auf solche Weise positioniert ist, dass die erste Oberfläche für eine Absorbierung von Energie aus dem Gebäudeinneren angeordnet ist und die zweite Oberfläche am oder angrenzend an den Hohlraum (10) angeordnet ist, so dass das Elektrizität erzeugende Element so angeordnet ist, dass es, wenn es relativ warmen externen Bedingungen ausgesetzt wird, Elektrizität erzeugt und Energie von seiner ersten zu seiner zweiten Oberfläche leitet, um diese auf Luft im Hohlraum (10) zu übertragen.

5. Wandstruktur nach einem der vorangehenden Ansprüche, wobei das Elektrizität erzeugende Element (20) eine thermoelektrische Schicht und/oder eine photovoltaische Schicht umfasst.

6. Wandstruktur nach einem der vorangehenden Ansprüche, ferner eine Energie absorbierende Schicht (30) oder eine thermische Masse oder PCM umfassend, wobei die Energie absorbierende Schicht (30) oder thermische Masse oder PCM am oder angrenzend an das Elektrizität erzeugende Element (20) angeordnet ist.

7. Wandstruktur nach Anspruch 6, wobei die Energie absorbierende Schicht (30) ein Isoliermaterial und/oder eine photovoltaische Schicht (50) umfasst.

8. Wandstruktur nach Anspruch 7, wobei die erste Oberfläche der thermoelektrischen Schicht am oder angrenzend an die photovoltaische Schicht (50) liegt und die zweite Oberfläche der thermoelektrischen Schicht am oder angrenzend an den Hohlraum (10) liegt.

9. Wandstruktur nach Anspruch 5, wobei die photovoltaische Schicht (50) so in der Struktur vorgesehen ist, dass sie der Außenumgebung der Struktur ausgesetzt ist, um Solarenergie zu absorbieren.

10. Wandstruktur nach einem der vorangehenden Ansprüche, wobei das Elektrizität erzeugende Element (20) ein organisches thermoelektrisches Material und/oder eine Kombination aus einem organischen thermoelektrischen Material als externe Schicht und einem dicken oder dünnen thermoelektrischen Folienmaterial umfasst.

11. Wandstruktur nach Anspruch 10,
wobei das
organische thermoelektrische Material so in der Struktur vorgesehen ist, dass es der Außenumgebung der Struktur ausgesetzt ist, um Solarenergie zu absorbieren.

12. Wandstruktur nach einem der vorangehenden Ansprüche, ferner eine Isolierschicht umfassend zur Anordnung am oder angrenzend an den Hohlraum (10) auf der Seite des Hohlraums (10), die der, auf der das Elektrizität erzeugende Element (20) angeordnet ist, entgegengesetzt ist.

13. Wandstruktur nach einem der vorangehenden Ansprüche, wobei das Elektrizität erzeugende Element (20) in Form eines planen Elements vorgesehen ist.

14. Wandstruktur nach einem der vorangehenden Ansprüche, wobei die Wandstruktur als Paneel vorgesehen ist.

15. Wandstruktur nach einem der vorangehenden Ansprüche, wobei die Wandstruktur als dynamische Isolierung oder als Wärmebrücke fungiert.

## Revendications

1. Structure murale pour bâtiment, comprenant :
une cavité (10) pour permettre à de l'air de circuler à travers la structure murale entre l'intérieur et l'extérieur du bâtiment entre les couches interne (2) et externe (4) du bâtiment; et
un élément générateur d'électricité (20) pour générer de l'électricité en utilisant le transfert thermique et qui est situé de manière à transférer de la chaleur depuis l'extérieur vers l'intérieur du bâtiment quand il est exposé à des conditions extérieures relativement chaudes (T_{HOT}) et depuis l'intérieur vers l'extérieur du bâtiment quand il est exposé à des conditions extérieures relativement fraîches (T_{COLD}), et
dans lequel l'élément générateur d'électricité (20) est situé de manière à favoriser un transfert d'énergie avec l'air situé dans la cavité (10).

2. Structure murale selon la revendication 1, dans laquelle le différentiel de température de l'air entre l'intérieur et l'extérieur du bâtiment amène l'air se trouvant dans la cavité (10) à s'écouler depuis l'intérieur vers l'extérieur du bâtiment quand il est exposé à des conditions extérieures relativement chaudes (T_{HOT}) et depuis l'extérieur vers l'intérieur du bâtiment quand il est exposé à des conditions extérieures relativement fraîches (T_{COLD}).

3. Structure murale selon la revendication 1, dans laquelle l'élément générateur d'électricité (20) est situé de manière à ce que l'énergie conduite par l'élément générateur d'électricité (20) soit transférable à la cavité (10) et/ou à ce que l'énergie transportée par la cavité (10) puisse être conduite vers l'élément générateur d'électricité (20).

4. Structure murale selon l'une quelconque des revendications précédentes, dans laquelle l'élément générateur d'électricité (20) a une première et une seconde surfaces, l'élément générateur d'électricité (20) étant positionné dans la structure de manière à ce que la première surface soit située de manière à absorber l'énergie de l'extérieur du bâtiment et la seconde surface soit située au niveau de ou adjacente à la cavité (10), de sorte que, lorsqu'il est exposé à des conditions extérieures relativement chaudes, l'élément générateur d'électricité (20) est situé de manière à générer de l'électricité et à conduire de l'énergie de sa première à sa seconde surfaces pour transfert dans l'air de la cavité (10).

5. Structure murale selon l'une quelconque des revendications précédentes, dans laquelle l'élément générateur d'électricité (20) comprend une couche thermoélectrique et/ou une couche photovoltaïque.

6. Structure murale selon l'une quelconque des revendications précédentes, comprenant en outre une couche absorbante d'énergie (30) ou une masse thermique ou PCM, dans laquelle la couche absorbante d'électricité (30) ou masse thermique ou PCM est située au niveau de ou adjacente à l'élément générateur d'électricité (20).

7. Structure murale selon la revendication 6, dans laquelle la couche absorbante d'énergie (30) comprend un matériau isolant et/ou une couche photovoltaïque (50).

8. Structure murale selon la revendication 7, dans laquelle la première surface de la couche thermoélectrique est au niveau de ou adjacente à la couche photovoltaïque (50) et la seconde surface de la couche thermoélectrique est au niveau de ou adjacente à la cavité (10).

9. Structure murale selon la revendication 5, dans laquelle la couche photovoltaïque (50) est prévue dans la structure de manière à ce qu'elle soit exposée à l'extérieur de la structure pour absorber l'énergie solaire.

10. Structure murale selon l'une quelconque des revendications précédentes, dans laquelle l'élément générateur d'électricité (20) comprend un matériau thermoélectrique organique et/ou une combinaison d'un matériau thermoélectrique organique faisant office de couche extérieure et un film de matériau thermoélectrique épais ou mince.

11. Structure murale selon la revendication 10,
dans laquelle le
le matériau thermoélectrique organique est prévu dans la structure de manière à ce qu'il soit exposé à l'extérieur de la structure pour absorber l'énergie solaire

12. Structure murale selon l'une quelconque des revendications précédentes, comprenant en outre une couche isolante à disposer au niveau de ou adjacente à la cavité (10) sur la face opposée de la cavité (10) depuis laquelle l'élément générateur d'électricité (20) est disposé.

13. Structure murale selon l'une quelconque des revendications précédentes, dans laquelle l'élément générateur d'électricité (20) se présente sous forme d'un élément planaire.

14. Structure murale selon l'une quelconque des revendications précédentes, dans laquelle la structure murale se présente sous forme d'un panneau.

15. Structure murale selon l'une quelconque des revendications précédentes, dans laquelle la structure murale fait office d'isolant dynamique ou de pont thermique.
